# FASCICULE DE BREVET EUROPEEN

(11) **EP 1 030 314 B1**
(45) Date de publication et mention de la délivrance du brevet: **15.08.2007**
(21) Numéro de dépôt: 00400118.6
(22) Date de dépôt: 18.01.2000
(51) Int. Cl.: G11C 29/00

(54) **Dispositif et procédé de test d'une mémoire non-volatile reprogrammable**
Einrichtung und Verfahren zur Prüfung eines nichtflüchtigen wiederprogrammierbaren Speichers
Device and method for testing a non-volatile reprogrammable memory

(30) Priorité: 22.01.1999 FR 9900692
(43) Date de publication de la demande: 23.08.2000
(73) Titulaire: COMMISSARIAT A L'ENERGIE ATOMIQUE, 75015 Paris (FR)
(72) Inventeur: Billiot, Gérard, 38240 Meylan (FR); Crochon, Elisabeth, 38320 Poisat (FR)
(74) Mandataire: Audier, Philippe André

(56) Documents cités:
- US-A- 5 264 742
- US-A- 5 345 413
- US-A- 5 394 367

## Description

### Domaine de l'invention

L'invention concerne un dispositif pour tester une mémoire non-volatile reprogrammable ayant des zones dédiées pouvant être protégées en lecture, écriture et/ou effacement. Elle concerne également le procédé utilisé dans ce dispositif, pour tester la mémoire dans son intégralité avant qu'elle ne soit mise à la disposition de l'utilisateur pour l'application à laquelle elle est destinée.

L'invention trouve des applications dans tous les domaines utilisant un système à mémoire non-volatile reprogrammable dont les accès sont réglementés. Elle peut être appliquée, en particulier, dans les systèmes d'identification sans contact comme les étiquettes d'identification pour le suivi d'objets ou la télébilleterie.

### Etat de la technique

Les systèmes à mémoire non-volatile reprogrammable ayant des zones dédiées protégeables en lecture, écriture et/ou effacement comportent des moyens pour gérer les droits d'accès à ces zones. Ces moyens consistent en une logique de contrôle intégrant des fusibles matériels ou logiciels qui autorisent, ou n'autorisent pas, la lecture, l'écriture et/ou l'effacement de tout ou partie du contenu de ces zones.

Les fusibles matériels, très fiables vis-à-vis de la fraude, ont l'inconvénient de nécessiter une surtension de claquage qui, dans certaines applications, n'est pas disponible. C'est notamment le cas dans la plupart des systèmes d'identification sans contact.

Les fusibles dits "logiciels" consistent en un ou plusieurs bits de la mémoire non-volatile reprogrammable, appelé(s) bit(s) de verrouillage. Dans le cas d'une mémoire ayant, par exemple, plusieurs zones dédiées, protégées en écriture et effacement, le bit de verrouillage de chaque zone autorise ou non l'accès de cette zone en écriture et effacement. Par exemple, si le bit est à "0", la zone mémoire dépendant de ce bit de verrouillage est accessible en écriture et effacement et, s'il est à "1", cette zone mémoire n'est accessible ni en écriture ni en effacement. Par contre, quelle que soit la valeur du bit de verrouillage, la zone mémoire considérée est accessible en lecture, puisque la lecture ne fait l'objet d'aucune protection.

Cependant, ce type de protection pose un problème lors de l'initialisation de la mémoire, avant son utilisation pour l'application cible à laquelle elle est destinée, c'est-à-dire avant d'être mise à la disposition de l'utilisateur. En effet, en fin de fabrication, la mémoire a une configuration aléatoire, c'est-à-dire que les bits peuvent être aussi bien à "0" qu'à "1". Il faut donc initialiser la mémoire, ce qui nécessite d'accéder à toutes les zones de la mémoire, quelle que soit la valeur des bits de verrouillage.

Deux méthodes sont généralement utilisées pour résoudre ce problème d'initialisation de la mémoire.

La première méthode consiste à ajouter, à la mémoire, des plots de test qui permettent d'accéder directement à la mémoire, en forçant certains états dans la logique de contrôle, c'est-à-dire certains bits de verrouillage.

Or, dans le cas des circuits intégrés, l'introduction de ces plots de test spécifiques augmente la taille des circuits et nécessite une étape de test supplémentaire, en fin de ligne de fabrication, ce qui augmente le coût de fabrication de ces circuits.

La seconde méthode, décrite dans le document US-A-5 394 367 consiste à utiliser un mot de configuration. Ce mot de configuration est un ensemble de bits sauvegardés dans une zone de configuration de la mémoire ; il protège l'accès aux bits de verrouillage de la façon suivante : tant que le mot de configuration est différent d'une valeur de blocage définie par l'utilisateur, toutes les zones protégées sont accessibles en lecture, écriture et effacement. Lorsque le mot de configuration est identique à la valeur de blocage, les droits d'accès aux zones protégées sont réglementés par les bits de verrouillage. La probabilité pour que la valeur de blocage soit celle du mot de configuration en sortie de fabrication est d'autant plus faible que le nombre de bits est grand et que la valeur de blocage est bien choisie. Cette méthode ne nécessitant l'introduction d'aucun élément supplémentaire, elle permet de minimiser la surface des circuits intégrés et de simplifier la mise en oeuvre de la phase d'initialisation.

Cependant, outre l'initialisation de la mémoire, il est nécessaire également, avant d'utiliser la mémoire dans son application cible, de vérifier le bon fonctionnement de tous les éléments de la mémoire et aussi de la logique de contrôle gérant les accès à la mémoire. Cette vérification doit être faite, de préférence, de façon exhaustive. Pour cela, il est nécessaire de pouvoir modifier aléatoirement toute la mémoire (y compris la zone de configuration) et tester tous les états de la logique de contrôle, et en particulier ceux imposés par les valeurs particulières de la zone de configuration. Or la méthode décrite dans le brevet US-A-5 394 467 ne permet pas cette vérification (ou test de la mémoire). Elle permet uniquement un fonctionnement en mode dit "normal" de vérification des droits d'accès à la mémoire.

<Le document US-A-5 394 467 décrit les caractéristiques des préambules des revendications 1 et 3.>

### Exposé de l'invention

L'invention a justement pour but de résoudre les problèmes des techniques décrites précédemment. A cette fin, elle propose un procédé et un dispositif permettant, un fonctionnement en deux modes : un mode "test", dans lequel toutes les zones mémoire sont accessibles quelle que soit la protection de ces zones, ce qui permet d'effectuer un test exhaustif de la mémoire et de la logique de contrôle ; et un mode "normal" dans lequel les protections d'accès sont irréversibles, la zone de configuration n'étant alors modifiable que dans le cas où les restrictions d'accès aux zones sont augmentées.

De façon plus précise, l'invention concerne un dispositif pour tester une mémoire non-volatile reprogrammable ayant des zones dédiées protégeables en lecture et/ou écriture et/ou effacement et dont les droits d'accès consistent en des mots de configuration sauvegardés dans une zone de configuration de la mémoire, ledit dispositif comportant des moyens d'émission/réception de messages et une unité logique de contrôle des messages reçus et des commandes d'accès à la mémoire, caractérisé en ce qu'il comporte au moins un registre temporaire assurant une émulation de ces droits d'accès de façon à rendre les protections d'accès réversibles lorsque la mémoire est dans un mode "test" et irréversibles dans les autres cas.

Avantageusement, le registre temporaire comporte :
- un registre de configuration de taille et de structure identiques à celles de la zone de configuration de la mémoire, et
- un registre d'indication de test.

L'invention concerne également un procédé de test d'une mémoire non-volatile reprogrammable utilisant le dispositif ci-dessus. Ce procédé se caractérise par le fait qu'il consiste à :
a) lire le contenu de la zone de configuration de la mémoire, transférer ce contenu dans le registre temporaire et initialiser le registre d'indication de test,
b) effectuer au moins une commande de modification du registre de configuration du registre temporaire en contrôlant les droits d'accès contenus dans le registre temporaire,
c) tester la modification du registre de configuration par des commandes de lecture et/ou écriture et/ou effacement sur les zones mémoire concernées.

Le procédé de l'invention consiste, entre les étapes a et b, à comparer la valeur du registre temporaire à une ou plusieurs valeur(s) de blocage prédéfinie(s) et écrite(s) dans la logique de contrôle (11) et, lorsque ces deux valeurs sont égales, à rendre les modifications de la zone de configuration irréversibles et lorsqu'elles sont différentes, à autoriser des modifications réversibles de la zone de configuration. Autrement dit, seule la valeur du mot de configuration mémoire (MCM) contrôle le verrouillage ou non des droits d'accès.

Selon un mode de réalisation de l'invention, les commandes de modification sont prises en compte immédiatement, le nouveau contenu de la zone de configuration étant aussitôt transféré dans le registre temporaire.

Selon un autre mode de réalisation, les commandes de modification de la zone de configuration sont prises en compte de façon différée par le registre temporaire, c'est-à-dire lorsque le signal « d'alimentation correcte » est à nouveau activé.

### Brève description des figures

La figure 1 représente schématiquement le dispositif de l'invention ; et

la figure 2 représente le diagramme fonctionnel du procédé utilisant ce dispositif.

### Description détaillée de modes de réalisation de l'invention

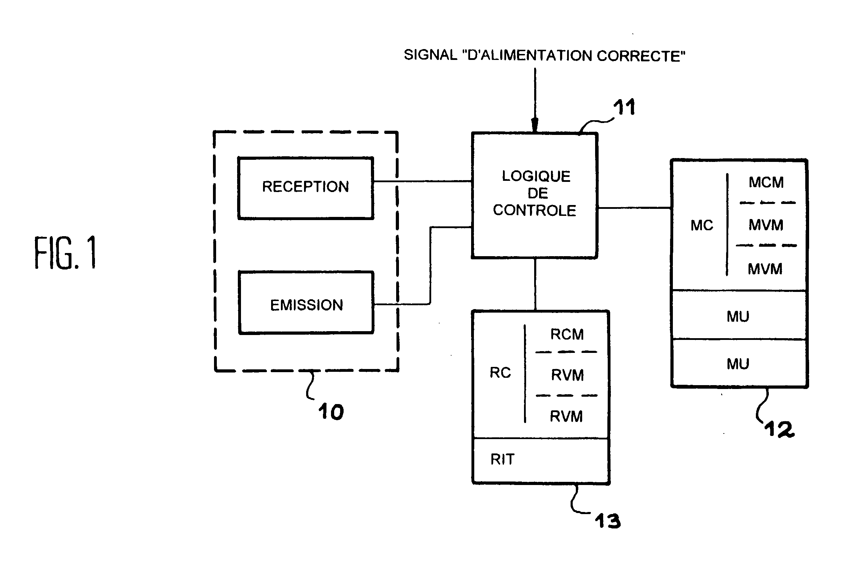

Sur la figure 1, on a représenté l'architecture générale du dispositif de l'invention. Ce dispositif comporte des moyens 10 d'émission/réception (E/R) de messages. Il comporte de plus une unité logique de contrôle des messages reçus et des commandes d'accès à la mémoire. Lorsque le signal « d'alimentation correcte » est actif, cette unité logique 11, appelée aussi "logique de contrôle", assure la lecture et l'analyse des messages reçus par les moyens d'E/R 10 ; elle assure aussi l'exécution des commandes d'accès à la mémoire 12 en fonction des droits d'accès de chaque zone de la mémoire ; elle assure enfin l'envoi d'un compte-rendu d'éxécution ou de non-éxécution de la commande par les moyens d'E/R 10.

En d'autres termes, c'est la logique de contrôle 11 qui, après vérification des droits d'accès d'une zone considérée de la mémoire, autorise ou non l'accès à cette zone mémoire. Cette logique de contrôle 11 est liée directement à la mémoire 12 qui est une mémoire non-volatile reprogrammable. Cette mémoire 12 peut être, par exemple, une EEPROM.

La mémoire 12 est divisée en plusieurs zones :
- une ou plusieurs zones propres à l'application cible, appelées mémoire(s) utilisateur MU. Dans le mode de réalisation représenté sur la figure 1, on a représenté le cas d'une mémoire ayant deux mémoires utilisateur MU ;
- une zone de configuration, appelée aussi mémoire de configuration MC, qui comporte elle-même plusieurs blocs :
   * un bloc qui contient un mot de configuration mémoire MCM ; ce mot de configuration est un ensemble de n bits qui code le droit d'accès à la zone de configuration MC et
   * un ou plusieurs blocs contenant chacun un mot de verrouillage mémoire MVM ; ce mot de verrouillage est un ensemble de m bits qui code les droits d'accès à la zone protégée de type mémoire utilisateur à laquelle il est associé.

Le dispositif de l'invention comporte en outre au moins un registre temporaire 13 qui assure la sauvegarde et l'émulation des droits d'accès à la mémoire. Le registre temporaire 13 comporte :
- un registre d'identification de test RIT dont le rôle est de valider ou non la phase de test de la mémoire, nommée mode « test ». Lorsque le registre RIT est sur "ON", le dispositif fonctionne en mode « test », c'est-à-dire le mode dans lequel le registre de configuration est modifiable de façon réversible ; lorsqu'il est sur "OFF", le dispositif fonctionne en mode dit "normal" c'est-à-dire un mode où le registre de configuration ne peut pas être modifié de façon indépendante de la zone de configuration ;
- un registre de configuration RC qui est l'image de la zone de configuration MC. Ce registre a donc la même taille que la zone de configuration et comporte les mêmes blocs :
   * un bloc qui constitue le registre de configuration mémoire RCM, identique au mot de configuration MCM ; et
   * un ou plusieurs blocs qui constitue(nt) chacun un registre de verrouillage mémoire RVM, identique au mot de verrouillage MVM.

Pour que le dispositif fonctionne en mode « test », il faut que ce mode soit activé. L'activation et la désactivation de ce mode « test », ainsi que la modification des droits d'accès en mode « test », sont réalisées au moyen de commandes spécifiques qui comprennent au moins :
- un mot clé dont le rôle est d'identifier et de séparer ces commandes des autres types de commandes, et
- un paramètre de valeur V codé sur w bits et dont le rôle est de modifier tout ou partie du registre de configuration RC. Selon un mode de réalisation préféré de l'invention, ce paramètre V prend deux valeurs particulières différentes V₀ et V₁ qui de plus permettent, respectivement, l'activation et la désactivation du mode « test », c'est-à-dire la modification du registre d'indication de test RIT.

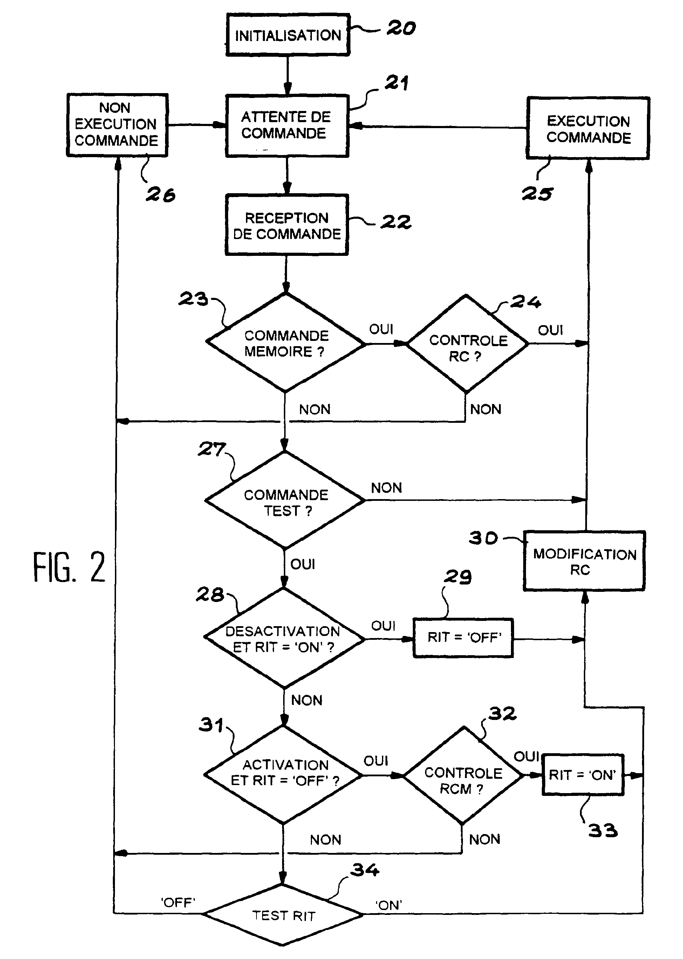

Ce dispositif met en oeuvre un procédé dont les principales étapes sont représentées sur la figure 2. Ce procédé se met en oeuvre dès que le signal « d'alimentation correcte » devient actif. En effet, lorsque le signal « d'alimentation correcte » devient actif, la logique de contrôle 11 passe dans un état d'initialisation 20, ce qui entraîne en particulier la lecture du contenu de la zone de configuration MC et son transfert dans le registre de configuration RC ainsi que le positionnement sur "OFF" du registre d'indication de test RIT. On comprendra que le contenu de la zone de configuration MC transféré dans le registre de configuration RC est ainsi sauvegardé. Le contenu du registre de configuration RC permet alors la gestion des accès des différentes zones de la mémoire 13.

Le dispositif se place alors dans un état 21 d'attente d'une commande. Dès qu'un message est réceptionné, la logique de contrôle analyse et identifie la commande associée à ce message (étape 22).

Un test 23 consiste ensuite à vérifier s'il s'agit d'une commande destinée à activer une opération de lecture, d'écriture ou d'effacement visant à affecter tout ou partie d'une des zones de la mémoire. Si c'est le cas, alors on effectue un contrôle des droits d'accès contenus dans le registre de configuration. Si l'accès à cette zone est autorisé, alors la commande est effectuée à l'étape 25. Si l'accès est refusé, la commande n'est pas exécutée (étape 26). Qu'il y ait eu ou non exécution de la commande, le dispositif se remet dans un état d'attente d'une commande.

S'il ne s'agit pas d'une commande visant à affecter une des zones de la mémoire, un test 27 consiste à vérifier s'il s'agit d'une commande pour passer en mode « test ». Si ce n'est pas le cas, la commande est exécutée en 25. Si c'est une commande de test, la logique de contrôle effectue une vérification sur le paramètre V de la commande et sur le registre RIT (étape 28) :
* si la commande correspond à une désactivation du mode « test », c'est-à-dire si le paramètre V a la valeur V₁, et si le registre RIT est sur "ON", alors le registre RIT est mis à "OFF" (étape 29) et la modification du registre de configuration RC est prise en compte (étape 30), ce qui signifie que la commande est exécutée ;
* si la réponse au test 28 est non, alors un test 31 vérifie si la commande correspond à une activation du mode « test », c'est-à-dire si le paramètre V a la valeur V_{0,} et si le registre RIT est à "OFF" :
   - si c'est le cas, alors la logique de contrôle vérifie que le registre de configuration mémoire RCM n'est pas à sa valeur de blocage (étape 32) ; si RCM n'est pas à sa valeur de blocage, alors le registre RIT est mis à "ON" (étape 33) et la modification du registre de configuration est effectuée (étape 30), ce qui signifie que la commande est exécutée. Si RCM est à sa valeur de blocage, la commande n'est pas exécutée (étape 26) ;
   - si ce n'est pas le cas, la logique 12 contrôle la valeur du registre RIT à l'étape 34 : si RIT est à "ON", l'étape 30 de modification du registre de configuration RC est effectuée suivant la valeur de V ; mais si RIT est à "OFF", la commande n'est pas exécutée (étape 26).

En d'autres termes, lorsque la commande concerne le mode « test » (réponse "OUI" au bloc 27), il existe alors quatre possibilités :
1. Quand la commande correspond à une désactivation du mode « test » et quand RIT est à "ON", alors le registre RIT est mis à "OFF" et la commande de désactivation est exécutée ;
2. Quand la commande correspond à une activation du mode « test » et quand RIT est à "OFF", alors un contrôle des droits d'accès à la zone de configuration MC est effectué par le registre RCM ; si RCM permet l'activation du mode « test », c'est-à-dire que RCM est différent d'une certaine valeur de blocage, alors le registre RIT est positionné à "ON" et la commande d'activation est exécutée. Sinon, aucune commande n'est exécutée et le registre RIT reste à "OFF".
3. Quand la commande correspond à une activation et que RIT est déjà à "ON", alors la commande d'activation est exécutée (uniquement dans le mode de réalisation où V₀ ≠ V₁).
4. Si la commande de test n'est ni une activation, ni une désactivation (c'est-à-dire V ≠ V₀ et V ≠ V₁), elle correspond à une modification du registre de configuration RC. Cela permet d'émuler un contenu pour la zone de configuration MC sans avoir à charger réellement ce contenu dans la zone de configuration et, par conséquent, de tester toutes les conditions d'accès à la mémoire, y compris celles à la zone de configuration, avec n'importe quelle valeur. Toutefois, cette commande est exécutée si et seulement si le registre RIT est à "ON".

Dans tous les cas où les commandes de type "test" sont exécutées, la valeur du paramètre V est utilisée pour modifier le contenu du registre de configuration. Ainsi la modification du registre de configuration RC s'effectue sous condition du contenu initial du registre de configuration RC et donc de la zone de configuration MC au moyen du registre d'indication de test RIT.

Il apparaît donc que tant que la valeur de blocage n'est pas écrite dans le mot de configuration de mémoire MCM, il est tout à fait possible de désactiver le circuit intégré (« le signal d'alimentation correct » inactif) et donc de retourner en mode test autant de fois que besoin est, sans nécessiter d'autres moyens de blocage notamment pour des tests de rétention et/ou d'endurance qui peuvent nécessiter des remises sous tension successives.

Lorsque le dispositif est jugé correct du point de vue des tests, la valeur de blocage est écrite dans le mot de configuration de mémoire MCM, les mots de verrouillage MVM sont réinitialisés ainsi que toutes les zones utilisateur MU avant toute opération de désactivation du mode « test ». Cette désactivation peut être effectuée par la commande de test décrite précédemment contenant un paramètre V₁, analysé comme une fin de test.

Dans la description précédente de la figure 2, on notera que les étapes 27 à 34 concernent uniquement le fonctionnement du dispositif de l'invention en mode « test ». Comme on vient de le voir, en mode « test », toutes les zones mémoires sont accessibles en lecture, écriture et effacement, dès lors que certaines conditions (données précédemment) sont vérifiées.

Les étapes 20 à 26 correspondent à un mode dit "normal", c'est-à-dire un mode dans lequel on peut utiliser la mémoire pour son fonctionnement dédié. En mode « normal », les zones mémoire sont accessibles uniquement dans la mesure où leurs droits d'accès sont vérifiés et que l'autorisation d'accéder à ces zones est donnée par le registre de configuration RC.

En mode "normal", une commande d'accès aux zones utilisateur est conditionnée par les droits d'accès mémorisés dans le registre de verrouillage mémoire RVM ; une commande de modification de la zone de configuration MC est conditionnée par le registre de configuration RCM. Si ce dernier est à la valeur de blocage, alors le bloc de mot de configuration mémoire MCM est protégé en écriture et effacement et les blocs MVM sont protégés en effacement, c'est-à-dire que les droits d'accès aux zones mémoire utilisateur MU deviennent de plus en plus restrictifs. Les protections d'accès sont alors irréversibles dans la mesure où le mot de verrouillage est inscrit dans le mot de configuration mémoire MCM donc transmis dans le registre de configuration mémoire RCM.

Par exemple, une zone applicative dédiée à l'enregistrement d'une clef secrète doit être initialement accessible en lecture, écriture et effacement. En fin de valorisation de la zone, c'est-à-dire après écriture et vérification de celle-ci, par exemple, par une lecture, cette zone sera protégée en lecture, afin que cette clef ne soit plus accessible directement, mais aussi en écriture/effacement si l'on ne souhaite écrire qu'une clef unique.

En mode « normal », pour toute commande de modification du contenu de la zone de configuration MC, des interactions entre la zone de configuration et le registre de configuration permettent la prise en compte de ces modifications. Ces interactions peuvent être régies de deux façons différentes :
* avec une prise en compte immédiate : lors de la réalisation par la logique de contrôle d'une opération de modification en écriture et/ou effacement effectuée sur la zone de configuration MC, la logique de contrôle effectue soit la modification de la zone de configuration puis un transfert du nouveau contenu de cette zone de configuration dans le registre de configuration, soit une modification simultanée sur la zone de configuration et sur le registre de configuration. Ainsi, la modification de la zone de configuration est immédiatement prise en compte au niveau du registre de configuration ;
* avec une prise en compte différée : lors de la réalisation par la logique de contrôle d'une opération de modification en écriture et/ou effacement effectuée sur la zone de configuration MC, la logique de contrôle effectue uniquement la modification de ladite zone MC. La validation de cette modification au niveau du registre de configuration RC se fait en interrompant la transaction en cours et donc en désactivant le signal « d'alimentation correcte » ; ainsi, lors de l'activation suivante de ce signal « d'alimentation correcte », le registre de configuration sera chargé avec le nouveau contenu de la zone de configuration, de sorte que les modifications réalisées lors de la transaction précédente seront effectives.

Quel que soit le type de prise en compte des modifications, dès que la programmation ou le transfert de la valeur de blocage dans le registre de configuration mémoire RCM est effectuée, le passage en mode « test » est interdit.

Le procédé de l'invention, qui vient d'être décrit permet de tester de manière réversible la mémoire, sans avoir à rapporter des éléments supplémentaires lors de sa fabrication, et à tout moment au cours de son utilisation. Ainsi la fabrication d'un circuit intégré comportant une mémoire non-volatile munie de ce dispositif présente un coût sensiblement inférieur à celui des techniques classiques, citées précédemment.

Ainsi cette invention peut être appliquée à de nombreux types de systèmes à mémoire et, en particulier, aux circuits intégrés, des cartes sans contact, des tickets de transport et des étiquettes d'identification.

Par exemple, elle peut être appliquée aux tickets de transport à usage unique, dont le coût doit être le plus faible possible. Dans ce cas, le cycle de vie du ticket peut être le suivant :
* fabrication : fonderie du circuit intégré et encartage du ticket sans test (si les procédés de fabrication ont des rendements qui le permettent). On diminue ainsi les coûts de test pendant l'ensemble du procédé de fabrication. Cependant, rien n'empêche les différents intervenants, tout au long du déroulement du procédé de fabrication, d'effectuer des tests par échantillonnage pour assurer la maîtrise des différentes étapes du procédé. Il est à noter que, si le test peut être effectué de façon idéale à l'étape de distribution, rien n'empêche que celui-ci soit effectué à d'autres étapes du procédé de fabrication. Pendant les étapes du procédé de fabrication du ticket, il est évident que le circuit intégré pourra être désactivé et être ainsi testé plusieurs fois pour des tests de rétention et/ou d'endurance, selon les besoins et les spécifications du produit, à la seule condition que le contenu de MCM à la désactivation soit différent du mot de blocage.
* distribution-vente : il s'agit de l'étape où le ticket est présent dans le distributeur de vente. Deux opérations distinctes sont alors effectuées.
   - test du ticket : l'invention permet un test exhaustif du ticket aussi bien de tous les points mémoire que de la logique de contrôle. Il est en particulier possible de vérifier la protection des zones dédiées. En fin de test, si le ticket est mauvais, il est rejeté et le ticket suivant est automatiquement positionné et testé. Si le ticket est bon, le mot de blocage est écrit dans la mémoire MVM (inhibition du mode "test"). Cette procédure de test peut se dérouler en temps masqué, pendant la valorisation du ticket précédent ou toute autre attente ; elle ne coûte donc pas de temps. D'autre part, aucun équipement de test spécifique n'est nécessaire, seul un programme de test spécifique doit être développé.
   - valorisation du ticket : lors de l'achat d'un ticket par un utilisateur, les informations concernant le trajet sont écrites, vérifiées et protégées (protection irréversible de la zone renseignée après inhibition du mode « test »)
* péage : le contrôle du ticket et le compostage du ticket s'effectuent d'une façon irréversible avec une grande fiabilité puisque l'ensemble des commandes aura été vérifié pendant le test.

## Revendications

1. Dispositif comprenant une mémoire (12) non volatile reprogrammàble ayant des zones de type mémoire utilisateur (MU) protégeables en lecture et/ou écriture et/ou effacement et dont des droits d'accès consistent en des mots (MVM) sauvegardés dans une zone de configuration (MC) de la mémoire (12), ledit dispositif pour tester et utiliser cette mémoire (12) comportant des moyens d'émission/réception (10) de messages, une unité logique de contrôle (11) des messages reçus et des commande d'accès à la mémoire et au moins un registre temporaire (13) où les mots (MVM) qui codent les droits d'accès sont transférés, **caractérisé en ce que** la logique de contrôle (11) comprend des moyens pour effectuer un contrôle des droits d'accès contenus dans le registre temporaire (13) pour autoriser ou refuser un accès aux dites zones de la mémoire (12) et **en ce que** le registre temporaire (13) comprend des moyens pour indiquer si le dispositif fonctionne en mode test, dans lequel le registre temporaire (13) est modifiable de façon réversible, ou en mode normal, dans lequel le registre temporaire (13) ne peut pas être modifié de façon indépendante de la zone de configuration (MC).

2. Dispositif selon la revendication 1, **caractérisé en ce que** le registre temporaire (13) comporte :
- un registre de configuration (RC) de taille et de structure identiques à celles de la zone de configuration (MC) de la mémoire (12), et
- un registre d'indication de test (RIT).

3. Procédé de test d'une mémoire non-volatile reprogrammable, mis en oeuvre par le dispositif selon la revendication 2, **caractérisé en ce qu'**il consiste à :
a) lire (20) le contenu de la zone de configuration (MC) de la mémoire (12), transférer ce contenu dans le registre temporaire (13) et initialiser le registre d'indication de test (RIT),
b) effectuer (27-34) au moins une commande de modification du registre de configuration (RC) du registre temporaire (13) pour modifier les droits d'accès contenus dans le registre temporaire (13),
c) tester (21-26) la mémoire, après la modification du registre de configuration (RC) par des commandes de lecture et/ou écriture et/ou effacement sur les zones mémoires de configuration (MC) et utilisateur (MU) .

4. Procédé selon la revendication 3, **caractérisé en ce qu'**il consiste, entre l'étape a et l'étape b, à comparer une valeur dans le registre temporaire (13) à une valeur de blocage prédéfinie et, lorsque ces deux valeurs sont égales, à rendre des modifications de la zone de configuration (MC) irréversibles, lorsqu'elles sont différentes, à autoriser des modifications réversibles de la zone de configuration (MC).

5. Procédé selon l'une quelconque des revendications 3 et 4, **caractérisé en ce que** des modifications de la zone de configuration (MC) sont prises en compte immédiatement, le nouveau contenu de la zone de configuration (MC) étant aussitôt transféré dans le registre temporaire (RC).

6. Procédé selon l'une quelconque des revendications 3 à 5, **caractérisé en ce que** des modifications de la zone de configuration (MC) sont prises en compte de manière différée.

## Claims

1. Device comprising a reprogrammable nonvolatile memory (12) having areas of the memory user (MU) type protectable in reading and/or writing and/or erasing and whereof the access rights consist of words (MVM) saved in a configuration area (MC) of the memory (12), said device for testing and using said memory (12) comprising transmission/reception means (10) for messages, a logic control unit (11) for said received messages and access control to the memory and at least one temporary register (13) where the words (MVM) encoding the access rights are transferred, **characterized in that** the control logic (11) comprises means for carrying out a control of the access rights contained in the temporary register (13) for authorizing or refusing access to said areas of memory (12) and **in that** the temporary register (13) comprises means for indicating whether the device functions in test mode, in which the temporary register (13) is reversibly modifiable, or in the normal mode, in which the temporary register (13) cannot be modified independently of configuration area (MC).

2. Device according to claim 1, **characterized in that** the temporary register comprises:
- a configuration register (RC) of size and structure identical to those of the memory (12) configuration area (MC) and
- a test indication register (RIT).

3. Test process for a reprogrammable nonvolatile memory, performed by the device according to claim 2, **characterized in that** it comprises:
a) reading (20) the content of the memory (12) configuration area (MC), transferring said content into the temporary register (13) and initializing the test indication register (RIT),
b) performing (27-34) at least one modification control of the configuration register (RC) of the temporary register for modifying the access rights contained in the temporary register (13),
c) testing (21-26) the memory after the modification of the configuration register (RC) by the reading and/or writing and/or erasing controls on the configuration and user memory areas (MC, MU).

4. Process according to claim 3, **characterized in that**, between stage a and stage b, it consists of comparing the value of the temporary register (13) with a previously defined blocking value and, when said two values are equal, making the modifications of the configuration area (MC) irreversible and, when they are different, authorizing reversible modifications of the configuration area (MC).

5. Process according to either of claims 3 and 4, **characterized in that** modifications of the configuration area (MC) are immediately taken into account, the new content of the configuration area (MC) being immediately transferred into the temporary register (RC).

6. Process according to any one of the claims 3 to 5, **characterized in that** modifications of the configuration area (MC) are taken into account in deferred manner.

## Patentansprüche

1. Vorrichtung mit einem wiederprogrammierbaren nichtflüchtigen Speicher (12), der Zonen des Typs Benutzerspeicher (MU) mit Lese- und/oder Schreib- und/oder Löschschutz umfasst, und dessen Zugriffsrechte aus Wörtern (MVM) bestehen, die in einer Konfigurationszone (MC) des Speichers (12) abgespeichert sind, wobei die genannte Vorrichtung zum Testen und Benutzen dieses Speichers (12) Einrichtungen (10) zum Senden und Empfangen von Mitteilungen, eine Logikeinheit (11) zur Kontrolle der empfangenen Mitteilungen und der Speicherzugriffsbefehle sowie wenigstens ein Temporärregister (13) umfasst, wohin die Wörter (MVM), die die Zugriffsrechte codieren, übertragen werden,
**dadurch gekennzeichnet, dass** die Kontrolllogik (11) Einrichtungen zur Durchführung einer Kontrolle der in dem Temporärregister (13) enthaltenen Zugriffsrechte umfasst, um einen Zugriff auf die genannten Zonen des Speichers (12) zuzulassen oder zu verweigern, und **dadurch**, dass das Temporärregister (13) Einrichtungen umfasst, die angeben, ob die Vorrichtung im Testmodus arbeitet, in dem das Temporärregister (13) auf reversible Weise modifizierbar ist, oder im Normalmodus, in dem das Temporärregister (13) nicht unabhängig von der Konfigurationszone (MC) modifiziert werden kann.

2. Vorrichtung nach Anspruch 1, **dadurch gekennzeichnet, dass** das Temporärregister (13) umfasst:
- ein Konfigurationsregister (RC), dessen Größe und Struktur der Konfigurationszone (MC) des Speichers (12) entspricht, und
- ein Testangaberegister (RIT).

3. Verfahren zum Testen eines wiederprogrammierbaren nichtflüchtigen Speichers, angewendet mit Hilfe der Vorrichtung nach Anspruch 2, **dadurch gekennzeichnet, dass** es darin besteht:
a) den Inhalt der Konfigurationszone (MC) des Speichers (12) zu lesen (20), diesen Inhalt in das Temporärregister (13) zu transferieren und das Testangaberegister (RIT) zu initialisieren,
b) wenigstens einen Befehl zur Modifikation des Konfigurationsregisters (RC) des Temporärregisters (13) auszuführen (27-34), um die in dem Temporärregister enthaltenen Zugriffsrechte zu modifizieren,
c) nach der Modifikation des Konfigurationsregisters (RC) durch Lese- und/oder Schreib-und/oder Löschbefehle in den Konfigurations- und Benutzerspeicherzonen (MC, MU) den Speicher zu testen (21-26).

4. Verfahren nach Anspruch 3, **dadurch gekennzeichnet, dass** es darin besteht, zwischen dem Schritt a und dem Schritt b einen Wert in dem Temporärregister (13) mit einem festgelegten Blockierwert zu vergleichen, und wenn diese beiden Werte gleich sind, Modifikationen der Konfigurationszone (MC) irreversibel zu machen, und wenn sie unterschiedlich sind, reversible Modifikationen der Konfigurationszone (MC) zuzulassen.

5. Verfahren nach einem der Ansprüche 3 und 4, **dadurch gekennzeichnet, dass** Modifikationen der Konfigurationszone (MC) sofort berücksichtigt werden, wobei der neue Inhalt der Konfigurationszone (MC) sogleich in das Temporärregister (RC) transferiert wird.

6. Verfahren nach einem der Ansprüche 3 bis 5, **dadurch gekennzeichnet, dass** Modifikationen der Konfigurationszone (MC) zeitlich versetzt berücksichtigt werden.
